# EUROPEAN PATENT APPLICATION

(11) **EP 2 408 281 A1**
(43) Date of publication of application: **18.01.2012**
(21) Application number: 09841422.0
(22) Date of filing: 17.11.2009
(51) Int. Cl.: H05K 1/14

(54) **CONNECTION STRUCTURE, CIRCUIT DEVICE, AND ELECTRONIC EQUIPMENT**

(30) Priority: 12.03.2009 JP 2009059755
(71) Applicant: Panasonic Corporation, Kadoma-shi Osaka 571-8501 (JP)
(72) Inventor: KAWABATA, Masahito, Osaka 540-6207 (JP)
(74) Representative: Grünecker, Kinkeldey, Stockmair & Schwanhäusser
(86) International application number: PCT/JP2009/006175
(87) International publication number: WO 2010/103591

(57) **Abstract**

To provide a connection structure in which terminals having different functions can be connected separately in an insulation state while suppressing the generation of problems such as a crack or an exfoliation of the terminal, a circuit device having the connection structure and an electronic equipment having the circuit device. A connection structure 30 for electrically and mechanically connecting between a connector board 20 and a circuit board 10, includes a frame 31 which at least has a first connection surface 31A connected to the connector board 20, a second connection surface 31B connected to the circuit board 10, and a first side surface 31C and a second side surface 31D each crossing with the first connection surface 31A and the second connection surface 31B; and a plurality of grounding terminals 32 each of which is formed at a part of each of the first connection surface 31A, the second connection surface 31B, the first side surface 31C and the second side surface 31D so as to form a loop shape in the cross-section of the frame, wherein the plurality of grounding terminals 32 are formed along the longitudinal direction of the frame 31 and at least two of the grounding terminals 32 are coupled so as to be conductible on the second side surface 31D.

## Description

### Technical Field

The present invention relates to a connection structure for electrically and mechanically connecting two members, a circuit device having the connection structure and an electronic equipment having the circuit device.

### Background Art

There has been known a circuit device in which a plurality of circuit boards are disposed in a laminated manner along the thickness direction of the boards and the respective circuit boards are electrically connected via a connection member disposed between the circuit boards (see Patent Literatures 1 and 2).

For example, a circuit device 100 of Patent Literature 1 as shown in Fig. 6 includes a first circuit board 111 and a second circuit board 121 disposed along the thickness direction of base members 110, 120, and a connection member 130 disposed between the first circuit board 111 and the second circuit board 121, wherein the first circuit board 111 and the second circuit board 121 are electrically connected by a terminal portion 131 provided at the connection member 130. In the circuit device 100 thus configured, a first circuit pattern 112 of the first circuit board 111 is connected to the terminal portion 131 of the connection member 130 and a second circuit pattern 122 of the second circuit board 121 is connected to the terminal portion 131 of the connection member 130.

Further, a circuit device 200 of Patent Literature 2 as shown in Fig. 7 is provided with a frame-shaped housing 210 having an inner peripheral portion 210A and an outer peripheral portion 210B, a plurality of connection terminal electrodes 220, 230 for connecting between the upper and lower surfaces of the housing 210, and bumps 240 provided on the plurality of connection terminal electrodes 220, 230 on at least one surface of the housing 210.

### Citation List

### Patent Literature

Patent Literature 1: WO 2008/035442
Patent Literature 2: JP-A-2008-159983

### Summary of the Invention

### Technical Problem

In recent years, the performance of electronic devices has been improved, and there has been increased a need for increasing the mounting density of components by further effectively utilizing the limited surface of a board. Thus, a circuit device such as a standoff card connector is proposed which is configured to laminate a plurality of boards three-dimensionally via a pillar-shaped member (hereinafter called "a connection member"). Further, in such circuit device, with respect to a structure, that is, the connection member, for electrically connecting a first member (a connector board, for example) to a second member (a circuit board, for example), it is also required to develop the connection structure for wiring two kinds of terminals (hereinafter called "different kinds of terminals") separately.

However, in the case of forming the connection member for the different kinds of terminals, securing of electric insulation becomes a very important problem in order to avoid the contact between these different kinds of terminals. Thus, in the case of realizing the connection structure with a simple configuration, it is considered to form the connection member by insulative resin etc. and to form the different kinds of terminals by being subjected to the metal plating etc. in a disposing state where the different kinds of terminals are mutually separated so as to secure the electric insulation therebetween.

In the case of forming the different kinds of terminals in the mutually separated state, the resin material of the connection member is exposed between the different kinds of terminals. In such a state, problems such as a crack or an exfoliation of the terminal likely occur inevitably at the external edge portion (a boundary portion between the connection member and the terminal) of the exposed coupling member.

The circuit device of Patent Literature 1 is configured as shown in Fig. 8, for example, in a manner that a terminal portion 131 of a rectangular shape in section is provided at the periphery of a beam member 140 as the connection member 130. That is, the terminal portion 131 of the connection member 130 has a simple connection structure where only one kind of the terminal is formed. Thus, the connection structure is not configured in a manner that the different kinds of terminals such as a plurality of grounding terminals and signal terminals are formed in a state of suppressing a crack and an exfoliation of the terminal.

On the other hand, the circuit device described in Patent Literature 2 has the structure which is configured to surely connect between a plurality of circuit boards each having a mechanical deformation such as a warp with a thin structure and to have the electromagnetic shielding function. However, just as the circuit device described in Patent Literature 1, the circuit device described in Patent Literature 2 is also not configured in a manner that different kinds of terminals are formed in a state of suppressing a crack and an exfoliation of the terminal.

In view of the aforesaid circumstances, an object of the invention is to provide a connection structure in which terminals are disposed while suppressing the generation of problems such as a crack or an exfoliation of the terminal, a circuit device having the connection structure and an electronic equipment having the circuit device.

### Solution to Problem

A connection structure according to the invention corresponds to a connection structure for connecting between a first member and a second member, the connection structure including a frame which at least includes a first connection surface to be connected to the first member, a second connection surface to be connected to the second member, and a first side surface and a second side surface each crossing with the first connection surface and the second connection surface; and a plurality of first connection terminals which are formed at a part of each of the first connection surface, the second connection surface, the first side surface and the second side surface so as to form a loop shape in a cross-section of the frame, wherein the plurality of first connection terminals are formed along a longitudinal direction of the frame and at least two of the first connection terminals are connected so as to be conductible on the first side surface.

Accordingly, in the frame of the connection structure for electrically and mechanically connecting between the first member and the second member, at least the two loops are coupled via a conductor on the outer sides thereof and so the first connection terminal integrally surrounds the frame in the loop manner. Thus, since there is no portion forming a notch where a crack of the frame or an exfoliation of the terminal occurs, the generation of a crack and an exfoliation of the terminal can be suppressed. Further, since the two first connection terminals are integrated at the outer sides thereof, these terminals mutually suppress the generation of a crack and an exfoliation of the terminal, whereby the generation of a crack and an exfoliation of the terminal can be further suppressed.

Further, as one aspect of the invention, in the aforesaid connection structure, a second connection terminal is further formed between two grounding terminals in the longitudinal direction of the frame. The second connection terminal is formed on the first connection surface, the second connection surface and the second side surface and is insulated from the first connection terminal.

Further, as one aspect of the invention, in the aforesaid connection structure, the first connection terminal is a grounding terminal and the second connection terminal is a signal terminal.

Although the signal terminal does not have a loop shape, since the two grounding terminals sandwich the frame to thereby generate a force preventing the generation of a crack and an exfoliation of the terminal, the generation of a crack of the signal terminal and an exfoliation of the terminal can also be effectively suppressed. Further, since the grounding terminal is disposed so as to surround the signal terminal, unnecessary radiation against the signal terminal can be effectively suppressed.

Further, as one aspect of the invention, in the aforesaid connection structure, the first connection terminal is configured so as to include a first chamfer portion of a plane shape at a corner portion where two outer sides constituting the frame cross.

Accordingly, also at the corner portion of the frame, the first connection terminal integrally surrounds the frame in the loop manner. Thus, since there is no portion forming a notch where a crack of the frame and an exfoliation of the terminal occurs, the generation of a crack and an exfoliation of the terminal can be suppressed. Further, since the two first connection terminals are integrated at the outer sides thereof, these terminals mutually suppress the generation of a crack and an exfoliation of the terminal, whereby the generation of a crack and an exfoliation of the terminal can be further suppressed.

In addition, since there is provided with the chamfer portion extending between the two outer sides (from the first side to the second side, for example), an area of the first connection terminal can be increased, so that the joining intensity at the time of joining with the land portion of the board can be improved.

Additionally, when the first connection terminal is also disposed at the corner portion of the frame, it becomes possible to hardly generate the exfoliation and to largely increase the joining intensity at the corner portion where a stress is applied most likely. As a result, the generation of a crack at the entirety of the frame and an exfoliation of the terminal can be effectively suppressed.

Further, as one aspect of the invention, in the aforesaid connection structure, the frame includes two outer sides and a beam portion for coupling the coupling portions of the two outer sides. A second chamfer portion of a plane shape is formed from the outer side to the beam portion at the coupling portion and the first connection terminal is formed so as to include the second chamfer portion.

Accordingly, since the first connection terminal surrounds the coupling portion between the beam portion and the outer side in a loop manner, there is no portion forming a notch which causes a crack and an exfoliation of the terminal at the coupling portion between the beam portion and the outer side of the first connection terminal, generation of a crack and an exfoliation of the terminal can be suppressed.

In addition, since the second chamfer portion is provided, the area of the first connection terminal can be made large, whereby the joining intensity at the time of joining with the land portion of the board can be improved.

Further, as one aspect of the invention, in the aforesaid connection structure, all the plurality of first connection terminals are electrically connected by a conductors which are located on the external side of the outer side of the frame and formed on the second side surface.

Accordingly, since all the first connection terminals are coupled to one another, the intensity can be further improved.

Further, as one aspect of the invention, the aforesaid connection structure includes a first board as the first member and a second board as the second member.

Accordingly, the circuit device having a large joining intensity between the first board and the second board can be provided.

Further, in the circuit device according to the invention, electronic components are mounted on the both side surfaces of at least one of the first board and the second board.

Accordingly, the circuit device, in which the joining intensity is large and a crack and an exfoliation of the terminal scarcely occurs, can be realized even in the case of joining a heavy board on which electronic components are mounted on the both surfaces of the first board and/or the both surfaces of the second board.

Further, an electronic equipment according to the invention includes the aforesaid connection structure or the aforesaid circuit device.

Accordingly, in an electronic equipment such as a mobile terminal to which a large stress is applied instantaneously due to a shock caused by a falling thereof etc., when the circuit device having a large joining intensity between the first board and the second board is provided, the electronic equipment can be provided which is excellent in the durability with respect to a shock caused by a falling thereof etc..

### Advantageous Effects of the Invention

In the connection structure according to the invention, a plurality of the first connection terminals each configured so as to form a loop shape in the cross-section of the frame are provided and at least the two first connection terminals are coupled so as to be conductive. Thus, the connection structure according to the invention has a merit that terminals having different functions can se coupled separately in an insulated state while suppressing the generation of problems such as a crack or an exfoliation of the terminal.

### Brief Description of the Drawings

Fig. 1 is a schematic perspective view showing the main portion of a mobile phone which is a kind of an electronic equipment having a circuit device to which a connection structure according to an embodiment of the invention is applied.
Fig. 2 is a sectional view along a line II-II in Fig. 1.
Fig. 3 is a plan view of a relay connector.
Fig. 4 is sectional views showing the relay connector portion of the circuit device shown in Fig. 1, in which (A) is a sectional view along a line IVA-IVA shown in Fig. 3 and shows the structure in which a grounding terminal and a signal terminal are disposed, and (B) is a sectional view along a line IVB-IVB shown in Fig. 3 and shows the structure in which only the grounding terminal is disposed
Fig. 5 is an enlarged view of an S section of Fig. 3 seen from an A direction.

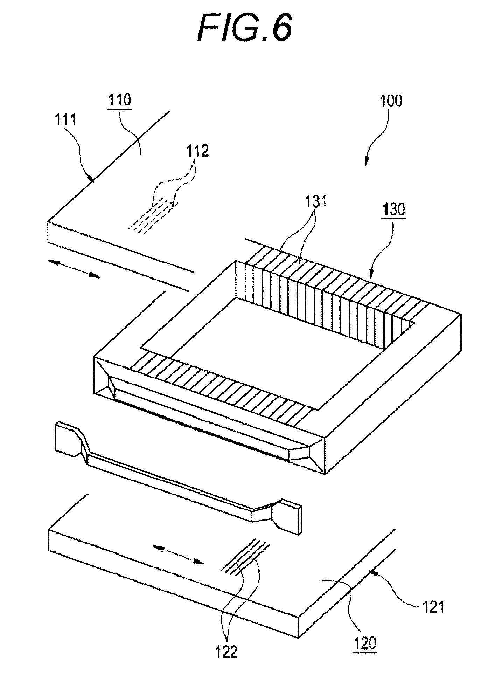

Fig. 6 is an exploded perspective view showing a circuit device of a related art.

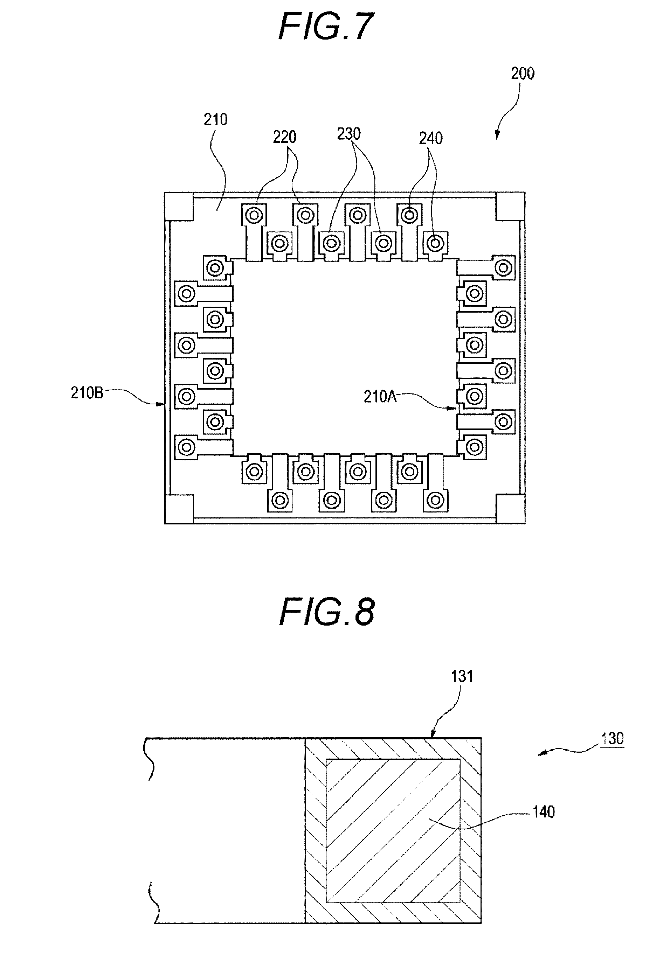

Fig. 7 is a plan view showing a circuit device of another related art.
Fig. 8 is a sectional view showing the coupling member of the circuit device in Fig. 6.

### Description of the Embodiments

Hereinafter, an embodiment of the invention will be explained in detail with reference to accompanying drawings.

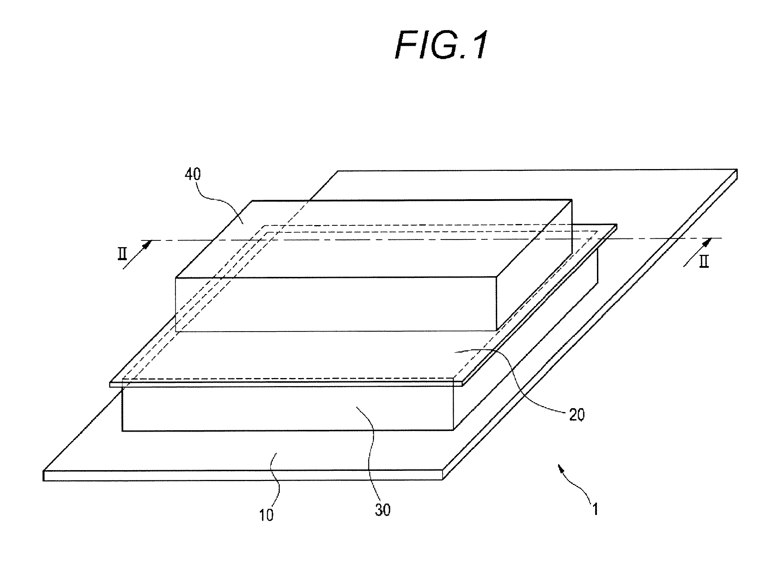

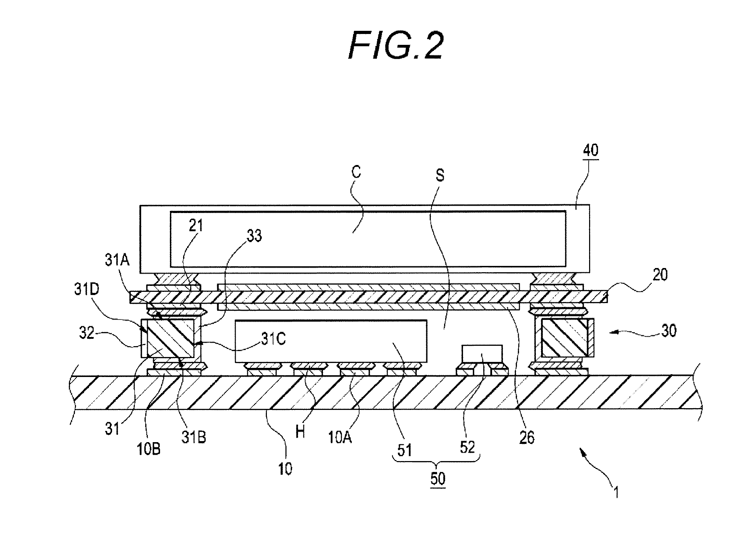

Fig. 1 and Fig. 2 show the main portion of a circuit device 1 to which a connection structure according to an aspect of the invention is applied. The connection structure and a circuit device according to an aspect of the invention can be used for an electronic equipment such as a mobile phone, preferably. A circuit device 1 according to the embodiment includes, as a general configuration, a connector board 20 constituting a first member, a circuit board 10 constituting a second member, a relay connector portion 30 (in other words, constituting a standoff portion) constituting the connection structure according to the invention, a card connector portion 40, and electronic components 50 mounted in a mounting space S provided between the circuit board 10 and the connector board 20.

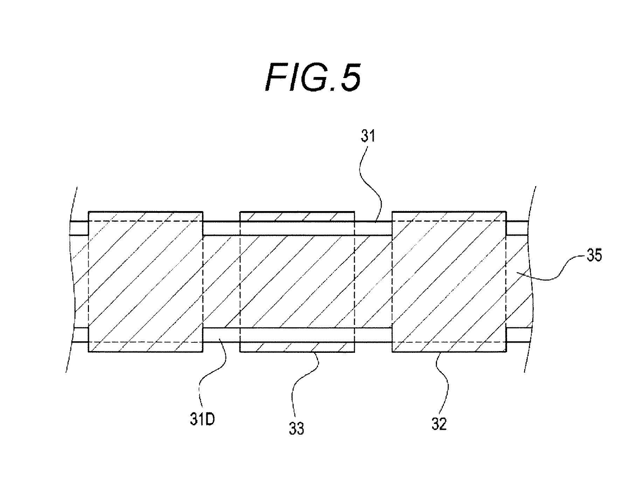

In this embodiment, the circuit board 10 supports the card connector portion 40 on one surface thereof (an upper surface in Fig. 1: hereinafter called "a surface") via the relay connector portion 30 and the connector board 20. The electronic components 50 are mounted on the surface of the circuit board 10 via board electrodes 10A and solders H, and also not-shown electronic components and a key sheet or a liquid crystal display device (LCD) etc. are mounted on the opposite surface thereof (a lower surface in Fig. 1). Further, as shown in Figs. 2 and 5, separately from the board electrodes 10A, land portions 10B are formed by the plating processing on the surface of the circuit board 10.

The connector board 20 includes a first surface (hereinafter called "an upper surface") opposing to the card connector portion 40 and a second surface (hereinafter called "a lower surface") opposing to the surface of the circuit board 10, and wiring patterns 26 are formed on the upper and lower surfaces.

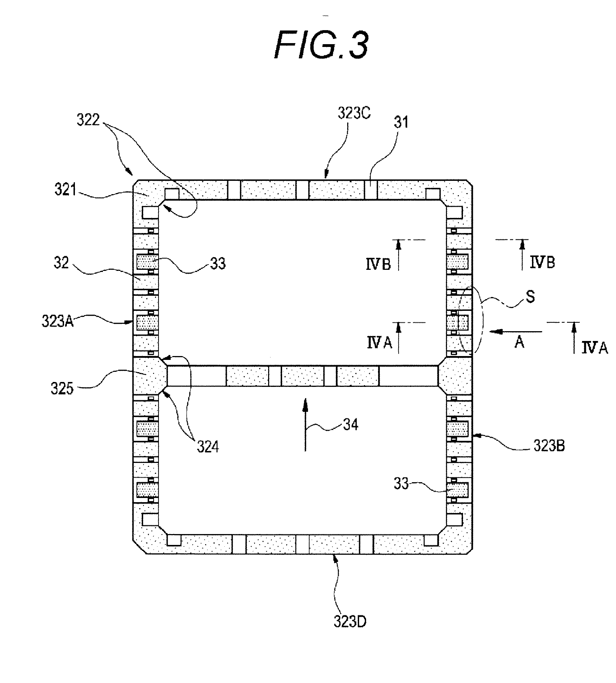

As shown in Fig. 3, the relay connector portion 30 includes a frame 31, first connection terminals 32 each constituting a grounding terminal, second connection terminals 33 each constituting a signal terminal, and a beam portion 34. The grounding terminal is a terminal which is electrically connected (grounded) to the ground and the signal terminal is a terminal which electrically couples the connector board 20 with the circuit board 10 and relays a signal between the connector board 20 and the circuit board 10.

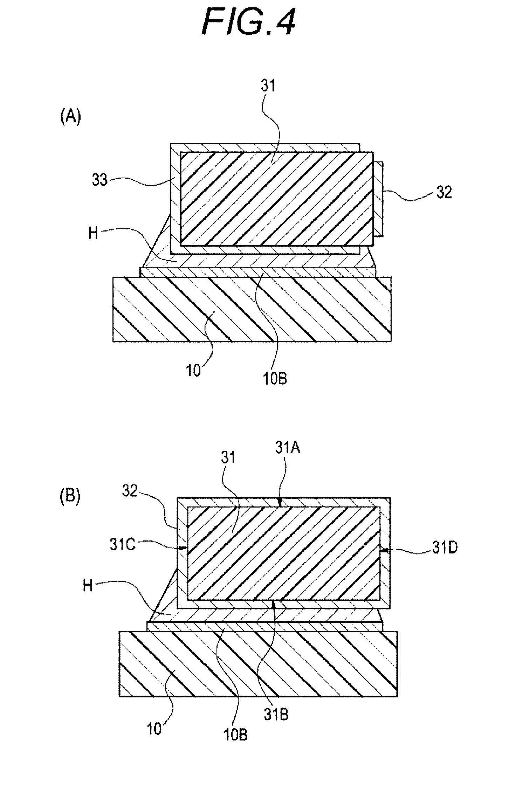

As shown in Fig. 3, the frame 31 is configured in an almost rectangular shape having four outer sides 323A to 323D by using suitable insulative resin (injection molding material such as LCP, PEEK, PEI, PES, PSF, SPS, PA, PPO or PPE). Further, as shown in (B) of Fig. 4, the frame 31 includes a first connection surface (upper surface) 31A to be connected to the connector board 20, a second connection surface (lower surface) 31B to be connected to the circuit board 10, and a first side surface 31C and a second side surface 31D respectively crossing with the first connection surface 31A and the second connection surface 31B.

The first connection terminal (hereinafter called "the grounding terminal") 32 is formed by the chemical plating on the outer surface of the frame 31 formed by the insulative resin. The grounding terminal 32 according to the aspect of the invention is configured to form a loop shape in the cross-section of the frame 31 (see (B) of Fig. 4) on at least a part of each of the first connection surface 31A, the second connection surface 31B, the first side surface 31C and the second side surface 31D of the frame 31. That is, the grounding terminal 32 includes a portion forming a loop shape in the cross-section of the frame 31 as shown in (B) of Fig. 4 and a portion formed only at the single surface (second side surface 31D) of the frame 31 as shown in (A) of Fig. 4.

In other words, at the portion necessary for disposing the signal terminal (signal line) 33 described later, the grounding terminal 32 according to the aspect of the invention is provided only at the single surface (31D) of the frame 31 except for the three surfaces where the signal terminal 33 is required to be disposed as shown in (A) of Fig. 4. On the other hand, the grounding terminal 32 is provided at the entire surfaces of the frame 31 at the portion where the signal terminal 33 is not required to be disposed. That is, at this portion, since the grounding terminal 32 is integrally formed at the entire surface as shown in (B) of Fig. 4, the cross-sectional shape of the frame 31 forms the loop shape as described above.

When the grounding terminal 32 is formed in the loop shape, the grounding terminal surrounds the frame (in the cross-section thereof) integrally over the four surfaces thereof (that is, the first connection surface (upper surface) 31A, the second connection surface (lower surface) 31B, the first side surface 31C and the second side surface 31D). Thus, since there is no portion forming a notch where the exfoliation of the grounding terminal 32 occurs, the generation of a crack and an exfoliation of the terminal can be effectively suppressed.

Further, a plurality of grounding terminals 32 are formed along the longitudinal direction (that is, a direction along the outer side) of the frame 31. At one of the first side surface 31C and the second side surface 31D of the frame 31 (the second side surface 31D in this embodiment), at least the two grounding terminals 32 are coupled via a conductor 35 having conductivity. That is, the two grounding terminals 32 are electrically and physically coupled so as to be conductible therebetween. In this manner, since the two grounding terminals 32 are integrated via the conductor 35 which is also a part of the grounding terminal 32 at the outer side portion thereof as shown in Fig. 5, for example, the generation of a crack and an exfoliation of the terminal can be effectively suppressed and prevented mutually.

In this embodiment, the grounding terminals 32 are formed over all the four outer sides 323A to 323D of the frame 31 as a whole. That is, the grounding terminals 32 are sequentially coupled in a manner that all the four outer sides are integrated, whereby the generation of a crack and an exfoliation of the terminal can be effectively suppressed while mutually reinforcing.

Further, as shown in Fig. 3, at a corner portion 321 where the two outer sides (for example, the outer side 323A in the vertical direction and the outer side 323C in the transversal direction) in particular among the four outer sides 323A to 323D constituting the frame 31 cross to each other, a first chamfer portion 322 of a plane shape (may be a flat plane shape or may not be a flat plane shape but a curved plane shape) is provided at each of the outer side and the inner side of the frame 31. In other words, also at the corner potion 321 of the frame 31, the grounding terminals 32 integrally surround the frame 31 in a loop manner. Thus, since there is no portion forming a notch which causes the exfoliation of the frame 31, the generation of a crack and an exfoliation of the terminal can be suppressed. Although the explanation is made as to the case where the first chamfer portion 322 is formed at each of the outer side and the inner side of the frame 31, the embodiment id not limited thereto. That is, in the case where the first chamfer portion 322 is provided only at the outer side or the first chamfer portion 322 is provided only at the inner side, the exfoliation of the terminal also can be suppressed by providing the grounding terminal 32 of the loop shape at the corner portion 321.

Further, the beam portion 34 is provided so as to couple between the two opposed frames 31 (two outer sides). Further, the beam portion 34 is formed by using suitable insulative resin. The frame 31 is coupled to the beam portion 34 via a coupling portion 325. The coupling portion 325 is disposed at a portion of the frame 31 except for the end portion of the outer side thereof. Further, the coupling portion 325 is provided with a second chamfer portion 324 of a plane shape (may be a flat plane shape or may not be a flat plane shape but a curved plane shape). The second chamfer portion 324 is also provided with the grounding terminal 32 over an area thereof from the outer sides 323A, 323B to the beam portion 34. That is, since the second chamfer portion 324 is also surrounded by the grounding terminal 32 in a loop manner, there is no portion forming a notch which causes a crack and an exfoliation of the terminal, so that the generation of a crack and an exfoliation of the terminal can also be suppressed at the second chamfer portion 324.

Furthermore, since the grounding terminal 32 is provided at each of the first chamfer portion 322 and the second chamfer portion 324, the area of the grounding terminal 32 can be made large, whereby the joining intensity at the time of joining with the land portions 10B, 21 of the board (the circuit board 10 and the connector board 20) can be improved.

In addition, in the frame 31 having the rectangular shape in its entire configuration, since the grounding terminals 32 are also disposed at the corner portions of the frame 31, a crack and an exfoliation of the terminal are hardly generated at the corner portions thereof where a stress is most likely applied. As a result, since the joining intensity can be made large, the generation of a crack and an exfoliation of the terminal can be effectively suppressed with respect to the entirety of the frame 31.

As well as the grounding terminal 32, the second connection terminal 33 (hereinafter called "the signal terminal") is formed by the chemical plating on the outer surface of the frame 31 formed by the insulative resin. In Fig. 3, each of the signal terminals 33 according to the aspect of the invention is formed between the adjacent two grounding terminals 32 in the longitudinal direction of the frame 31 (the direction along each of the two outer sides 323A, 323B in Fig. 3). That is, as shown in (A) of Fig. 4, the signal terminal 33 is formed on the first connection surface (upper surface) 31A, the second connection surface (lower surface) 31B and the first side surface 31C where the grounding terminal 32 is not coupled. In this manner, the signal terminal is separated and insulated from the grounding terminal 32.

The electronic component 50 is mounted by utilizing the mounting space S formed between the mounting space S formed between the card connector portion 40 and the connector board 20 on the surface of the circuit board 10. As the electronic components 50, surface mounting devices (SMD) such as a semiconductor package component 51 and an LCR circuit chip component 52 are used. The electronic components are mounted on the surface of the circuit board 10. The electronic components 50 may be attached on the connector board 20 side instead of the circuit board 10 side so long as they are disposed in the mounting space S formed between the circuit board 10 and the connector board 20.

Thus, according to this embodiment, the grounding terminals 32 and the signal terminals 33 can be formed on the frame 31 separately in an insulated state therebetween while suppressing the generation of the problems such as a crack or an exfoliation of the terminal. Accordingly, the circuit device in which the joining intensity is secured can be realized in the case of using the connector board 20 as the first board and the circuit board 10 as the second board.

Further, according to this embodiment, the circuit device, in which the joining intensity is large and a crack and an exfoliation of the terminal scarcely occurs, can be realized even in the case of joining a heavy board on which electronic components are mounted on at least one surface of the connector board 20 and (or) at least one surface of the circuit board 10.

Furthermore, according to this embodiment, in an electronic equipment such as a mobile terminal to which a large stress is applied instantaneously due to a shock caused by a falling thereof etc., when the circuit device having a large joining intensity between the connector board 20 and the circuit board 10 is provided, the electronic equipment can be realized which is excellent in the durability with respect to a shock caused by a falling thereof etc..

In this embodiment, all the plurality of first connection terminals are disposed so as to locate on the external side of the four outer sides of the frame and are electrically connected via the conductors which are formed on the second side surfaces of all the four outer sides thereof. According to this configuration, since all the first connection terminals are coupled, the intensity can be improved. However, all the first connection terminals are not necessarily coupled via the conductors, and plural ones of the first connection terminals may be coupled via the conductors.

The invention is not limited to the aforesaid embodiment, and the changes and applications performed by persons skilled in the art based on the description of the specification and well-known techniques are estimated and contained within the range of the protection of the invention.

The present application is based on Japanese Patent Application No. 2009-059755 filed on March 12, 2009, the contents of which is incorporated herein as a reference.

### Industrial Applicability

The invention has an effect that generation of problems can be suppressed effectively at two kinds of terminals having different functions which are provided on the same frame in the separated and insulated state to each other. The invention is useful for the circuit device provided with the connection structure and the electronic equipment having the circuit device.

### Reference Signs List

- 1: circuit device
- 10: first member (circuit board)
- 10A: board electrode
- 10B: land portion
- 20: second member (connector board)
- 21: land portion (outer peripheral land)
- 30: relay connector portion (connection structure)
- 31: frame
- 31A: first connection surface
- 31B: second connection surface
- 31C: first side surface
- 31D: second side surface
- 32: first connection terminal (grounding terminal)
- 321: corner portion
- 322: first chamfer portion
- 323A-323D: outer side
- 324: second chamfer portion
- 325: coupling portion
- 33: second connection terminal (signal terminal)
- 34: beam portion
- 35: conductor (outer side conductor)
- 40: card connector portion
- 50: electronic component
- 51: semiconductor package component
- 52: LCR circuit chip component
- C: card
- H: solder
- S: mounting space

## Claims

1. A connection structure for connecting between a first member and a second member, the connection structure comprising:
a frame which at least includes a first connection surface to be connected to the first member, a second connection surface to be connected to the second member, and a first side surface and a second side surface each crossing with the first connection surface and the second connection surface; and
a plurality of first connection terminals, each of which is formed at a part of each of the first connection surface, the second connection surface, the first side surface and the second side surface so as to form a loop shape in a cross-section of the frame, wherein
the plurality of first connection terminals are formed along a longitudinal direction of the frame, and
at least two of the first connection terminals are connected so as to be conductible on the first side surface.

2. The connection structure according to claim 1, wherein
a second connection terminal is further formed between two of the first connection terminals in a longitudinal direction of the frame, and
the second connection terminal is formed on the first connection surface, the second connection surface and the second side surface and is insulated from the first connection terminal.

3. The connection structure according to claim 2, wherein
the first connection terminal is a grounding terminal to be connected to a ground, and
the second connection terminal is a signal terminal which electrically connects the first member to the second member.

4. The connection structure according to claim 1, wherein
the first connection terminal is configured so as to include a first chamfer portion of a plane shape at a corner portion where two outer sides constituting the frame cross.

5. The connection structure according to claim 1, wherein
the frame includes two outer sides and a beam portion for coupling the coupling portions of the two outer sides, and
a second chamfer portion of a plane shape is formed from the outer side to the beam portion at the coupling portions and the first connection terminal is formed so as to include the second chamfer portion.

6. The connection structure according to any one of claims 1 to 5, wherein
all the plurality of first connection terminals are electrically connected by a conductor which is located on the external side of the outer side of the frame and formed on the second side surface.

7. A circuit device comprising:
the connection structure according to any one of claims 1 to 6;
a first board as the first member; and
a second board as the second member.

8. The circuit device according to claim 7, wherein
electronic components are mounted on a surface of at least one of the first board and the second board.

9. An electronic equipment comprising:
the connection structure as set forth in any one of claims 1 to 6; or
the circuit device as set forth in claim 7 or 8.

## Amended claims

### Amended claims under Art. 19.1 PCT

**1.** *(Amended)* A connection structure for electrically and

**.** echanically connecting between a first member and a second member, the connection structure comprising:
a frame which at least includes a first connection surface to be connected to the first member, a second connection surface to be connected to the second member, and a first side surface and a second side surface each crossing with the first connection surface and the second connection surface;
at least two first connection terminals, each of which is formed at a part of each of the first connection surface, the second connection surface, the first side surface and the second side surface so as to form a loop shape in a cross-section of the frame, the two first connection terminals being formed along a longitudinal direction of the frame; and
a second connection terminal formed between the two first connection terminals, and formed on the first connection surface, the second connection surface and the second side surface, wherein
the two first connection terminals are connected to each other so as to be conductible on the first side surface, and the second connection terminal is insulated from the two first connection terminal.

**2.** *(Amended)* The connection structure according to claim 1, wherein
the first connection terminal is a grounding terminal to be connected to a ground, and
the second connection terminal is a signal terminal which electrically connects the first member to the second member.

**3.** *(Amended)* The connection structure according to claim 1, wherein
the first connection terminal is configured so as to include a first chamfer portion of a plane shape at a corner portion where two outer sides constituting the frame cross.

**4.** *(Amended)* The connection structure according to claim 1, wherein
the frame includes two outer sides and a beam portion for coupling the coupling portions of the two outer sides, and
a second chamfer portion of a plane shape is formed from the outer side to the beam portion at the coupling portions and the first connection terminal is formed so as to include the second chamfer portion.

**5.** *(Amended)* The connection structure according to any one of claims 1 to 4, wherein
the connection structure comprises a conductor which is formed on the external side of the outer side of the frame and formed on the second side surface, and
the plurality of first connection terminals are electrically connected by the conductor.

**6.** *(Amended)* A circuit device comprising:
the connection structure according to any one of claims 1 to 5;
a first board as the first member; and
a second board as the second member.

**7.** *(Amended)* The circuit device according to claim 6, wherein
electronic components are mounted on a surface of at least one of the first board and the second board.

**8.** *(Amended)* An electronic equipment comprising:
the connection structure as set forth in any one of claims 1 to 5; or
the circuit device as set forth in claim 6 or 7.

**9.** *(Cancelled)*
